# EUROPEAN PATENT APPLICATION

(11) **EP 4 832 728 A1**
(43) Date of publication of application: **28.10.2026**
(21) Application number: 26168063.1
(22) Date of filing: 26.03.2026
(51) Int. Cl.: H10P 58/00

(54) **SEMICONDUCTOR DIE SINGULATION FEATURE AND METHOD THEREFOR**

(30) Priority: 25.04.2025 CN 202510537272
(71) Applicant: NXP USA, Inc, Austin, TX 78735 (US)
(72) Inventor: Zhang, Xinyao, 5656AG Eindhoven (NL); Wang, Miao, 5656AG Eindhoven (NL); Lv, Xiaowei, 5656AG Eindhoven (NL)
(74) Representative: Schwarzweller, Thomas

(57) **Abstract**

A method of forming a semiconductor device is provided. The method includes forming a singulation feature within singulation lane regions at an active side of a semiconductor wafer. A base portion of the singulation feature has a width greater than that of a top portion of the singulation feature. A cut is formed at a backside of the semiconductor wafer along the singulation lane regions such that the cut extends to the base portion of the singulation feature. The semiconductor wafer is mounted onto a dicing tape and laterally stretched to singulate the semiconductor wafer into a plurality of individual semiconductor die.

## Description

### Background

### Field

This disclosure relates generally to semiconductor device packaging, and more specifically, to semiconductor die singulation feature and method of forming the same.

### Related Art

Today, there is an increasing trend to include sophisticated semiconductor devices in products and systems that are used every day. These sophisticated semiconductor devices are formed from a plurality of integrated circuits on a semiconductor wafer. As the complexity of these integrated circuits increases, fewer integrated circuits can be formed on the wafer. Accordingly, significant challenges exist in accommodating complex integrated circuits while minimizing defects and maximizing the number individual devices that can be formed from a wafer.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified plan view, an example semiconductor wafer having an embedded singulation feature in accordance with an embodiment.
FIG. 2 through FIG. 7 illustrate, in simplified cross-sectional views, an example semiconductor wafer portion having the embedded singulation feature at various stages of manufacture in accordance with an embodiment.
FIG. 8 through FIG. 14 illustrate, in simplified cross-sectional views, an example semiconductor wafer portion having an alternative embedded singulation feature at various stages of manufacture in accordance with an embodiment.

### Detailed Description

Generally, there is provided, a semiconductor wafer singulation method having an embedded singulation feature. The semiconductor wafer includes a plurality of die sites surrounded by singulation lanes. The singulation lanes of the semiconductor wafer include an embedded singulation feature at the active side which substantially surrounds each die site. The singulation feature is formed as hollow structure embedded within dielectric layers during the formation of the back end of line portion of the semiconductor wafer. The singulation feature has a teardrop-like shape in a cross-sectional view. For example, a the singulation feature has a very narrow top portion near the top surface of the semiconductor wafer and a progressively wider shape further from the top surface of the semiconductor wafer. A cut is formed from the back of the semiconductor wafer along the singulation lanes. The cut is vertically aligned with the singulation feature and extends from the bottom surface of the wafer to the singulation feature. With the semiconductor wafer adhered on a dicing tape, the dicing tape is expanded to singulate the semiconductor wafer into a plurality of semiconductor die. The singulation feature is configured to guide crack propagation to a portion of the semiconductor wafer directly overlying the top portion of the singulation feature as the dicing tape is stretched during a wafer singulation procedure. By singulating the semiconductor wafer into the plurality of individual semiconductor die in this manner, each semiconductor die is virtually free of surface damage at the active side commonly associated with conventional singulation methods. Further, each semiconductor die has a resulting sidewall profile allowing the active area to be maximized and the width of the singulation lane regions to be minimized thus enabling more possible die per wafer.

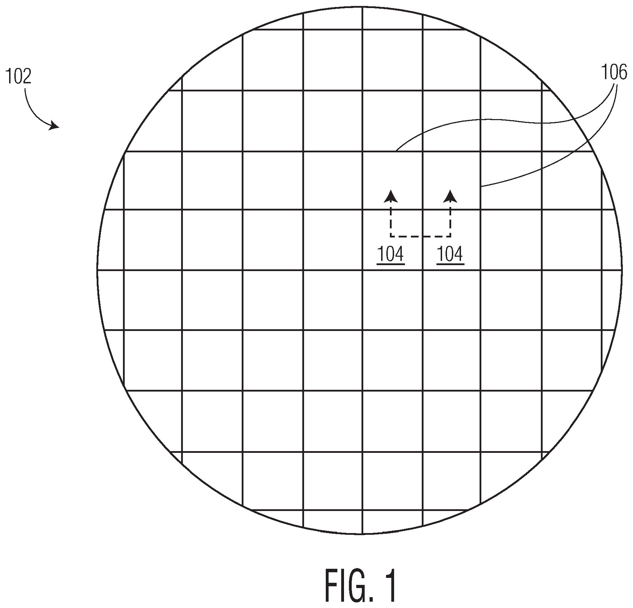

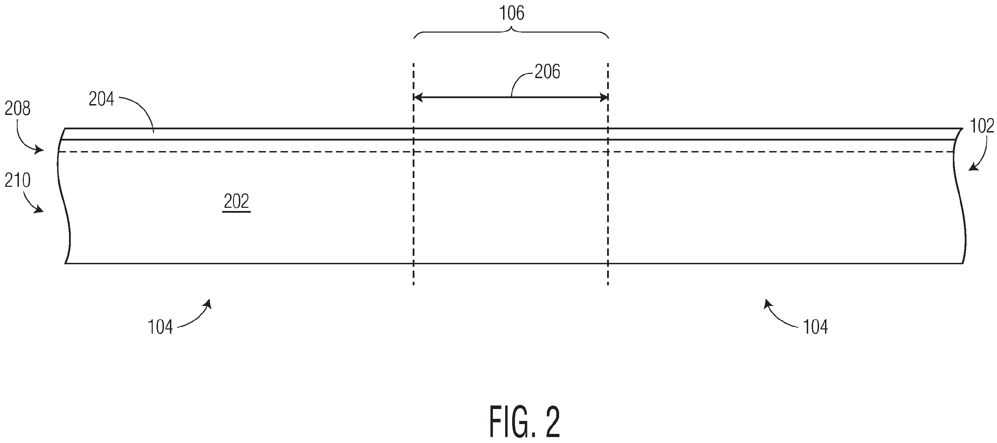

FIG. 1 illustrates, in a simplified plan view, an example semiconductor wafer 102 having an embedded singulation feature (not shown) at a stage of manufacture in accordance with an embodiment. At this stage, the semiconductor wafer 102 includes a plurality of semiconductor die sites 104 surrounded by singulation lane regions 106 (e.g., scribe streets, saw lanes). The term "die site" as used herein generally refers to an individual integrated circuit semiconductor die while in wafer form. Simplified cross-sectional views of the example semiconductor wafer 102 taken along line A-A at stages of manufacture are depicted in FIG. 2 through FIG. 7 and FIG. 8 through FIG. 14.

The semiconductor wafer 102 has an active side (e.g., major side having circuitry) and a backside (e.g., major side opposite of the active side). The die sites (e.g., semiconductor die) 104 include bond pads (not shown) formed at the active sides, for example. In this embodiment, the semiconductor wafer 102 is oriented with the active side up. The semiconductor wafer 102 may be formed from any suitable semiconductor material, such as silicon, germanium, gallium arsenide, gallium nitride, and the like. The semiconductor die at die sites 104 may include any digital circuits, analog circuits, RF circuits, power circuits, sensors, memory, processor, the like, and combinations thereof, for example.

FIG. 2 through FIG. 7 illustrate, in simplified active-side-up cross-sectional views, the example semiconductor wafer 102 having an embedded singulation feature at stages of manufacture in accordance with an embodiment. The cross-sectional views depicted in FIG. 2 through FIG. 7 show portions of neighboring die sites 104 separated from one another by way of singulation lane 106, for example.

FIG. 2 illustrates, in a simplified cross-sectional view, the example semiconductor wafer 102 at a stage of manufacture in accordance with an embodiment. At this stage, the semiconductor wafer 102 includes a substrate portion 202 and a base dielectric layer 204 formed over the substrate portion. In this embodiment, the dielectric layer 204 is associated with a dielectric layer of the back end of line (BEOL) portion of the semiconductor wafer 102. For example, the BEOL portion of the semiconductor wafer 102 generally includes conductive (e.g., metal) interconnect layers separated from one another by way of dielectric layers. The term "conductive," as used herein, generally refers to electrical conductivity unless otherwise described.

For illustration purposes, the substrate portion 202 includes a front end of line (FEOL) portion 208 and a bulk portion 210 of the semiconductor wafer 102. The FEOL portion 208 of the semiconductor wafer 102 generally includes transistors and circuit components formed in the substrate portion, for example. Accordingly, the BEOL portion of the semiconductor wafer 102 is formed over the FEOL portion 208. In this embodiment, the singulation lane region 106 is formed having a predetermined width dimension 206. By forming the embedded singulation feature within the singulation lane 106, the width dimension 206 may be reduced (e.g., width dimension equal to 30 microns or less) thus allowing more die per wafer. Features of the semiconductor wafer 102 such as interconnecting traces of the BEOL and circuitry of the FEOL are not shown for illustration purposes.

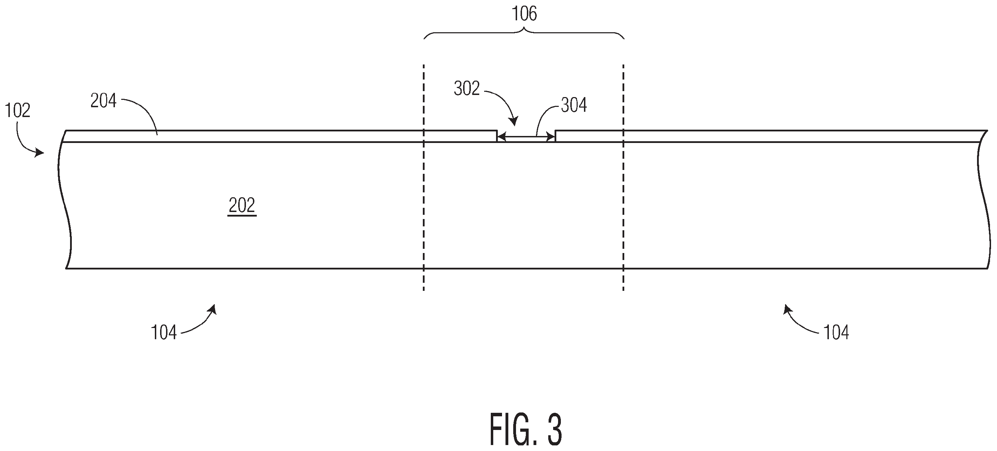

FIG. 3 illustrates, in a simplified cross-sectional view, the example semiconductor wafer 102 at a subsequent stage of manufacture in accordance with an embodiment. At this stage, an opening 302 is formed through the dielectric layer 204 exposing an underlying portion of the semiconductor wafer 102 within the singulation lane region 106. The opening 302 be formed by way of known etch or laser drilling techniques, for example. In this embodiment, the opening 302 is substantially centered within the singulation lane region 106 and configured to substantially surround each die site 104. The bottom of the opening 302 may be characterized as the bottom or base portion of the embedded singulation feature, for example. In this embodiment, the opening 302 is formed having a predetermined width dimension 304 in a range of approximately 2 microns to 5 microns.

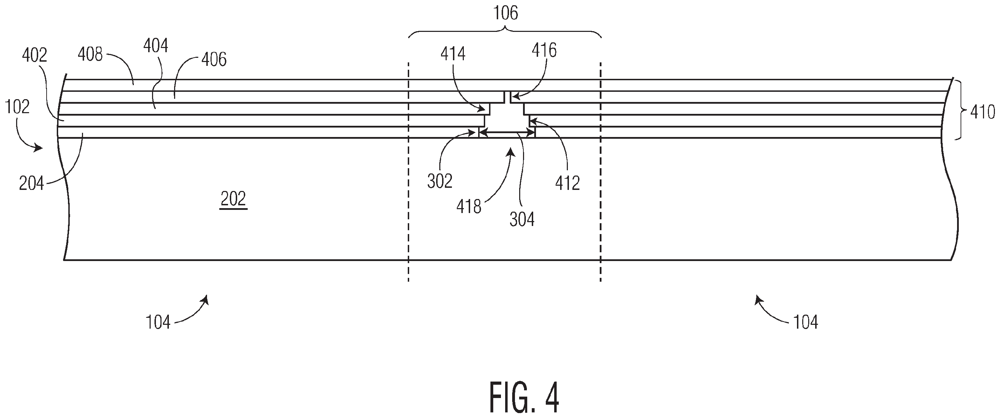

FIG. 4 illustrates, in a simplified cross-sectional view, the example semiconductor wafer 102 at a subsequent stage of manufacture in accordance with an embodiment. At this stage, dielectric layers 402-406 and respective openings 412-416 are successively formed over the base dielectric layer 204. In this embodiment, the embedded singulation feature 418 is formed during the formation of the BEOL portion 410 of the semiconductor wafer 102.

The dielectric layer 402 is formed over the dielectric layer 204. Corresponding opening 412 is subsequently formed through the dielectric layer 402 such that the width of the opening 412 is smaller than the width 304 of the opening 302. Similarly, the dielectric layer 404 is formed over the dielectric layer 402 with corresponding opening 414 subsequently formed through the dielectric layer 404 such that the width of the opening 414 is smaller than the width of the opening 412. Likewise, the dielectric layer 406 is formed over the dielectric layer 404 with corresponding opening 416 subsequently formed through the dielectric layer 406 such that the width of the opening 416 is smaller than the width of the opening 414. The dielectric layer 408 is formed over the dielectric layer 406 and the opening 416 to embed the singulation feature 418. Subsequent layers which may be formed over the dielectric layer 408 are not shown for illustration purposes.

The top of the opening 416 may be characterized as the tip or top portion of the embedded singulation feature 418, for example. The openings 412-416 may be formed by way of known techniques (e.g., etching, laser drilling). In this embodiment, the embedded singulation feature 418 is a hollow, air-filled structure formed in the singulation lane regions 106 and thus, substantially surrounds each die site 104 of the semiconductor wafer 102. In this embodiment, the embedded singulation feature 418 includes a cross-sectional appearance having a substantially teardrop shape. For example, the top portion of the singulation feature 418 is substantially narrower than the base portion of the singulation feature. Each underlying opening (302, 412, 414) forming the singulation feature 418 is progressively wider than the opening 416 at the top portion of the singulation feature.

In this embodiment, the dielectric layers 402-406 are associated with corresponding dielectric layers of the BEOL portion 410 of the semiconductor wafer 102. The dielectric layer 408 may be formed from a dielectric layer associated with a dielectric layer of the BEOL portion 410 or may be formed from one or more other dielectric and/or passivation layers. The number of dielectric layers, size and shape of respective openings are chosen for illustration purposes.

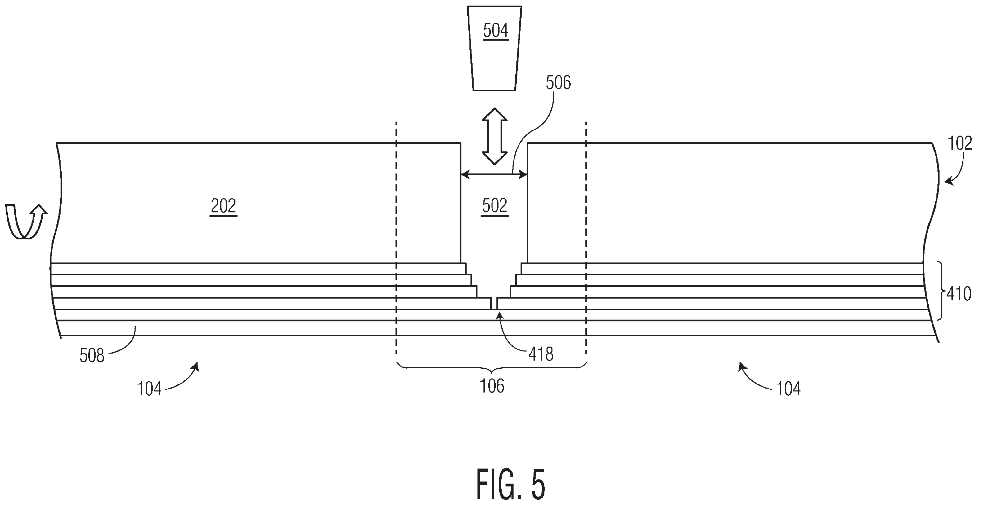

FIG. 5 illustrates, in a simplified cross-sectional view, the example semiconductor wafer 102 at a subsequent stage of manufacture in accordance with an embodiment. At this stage, a cut 502 is formed at the backside of the semiconductor wafer 102 along the singulation lane regions 106 and substantially aligned with the embedded singulation feature 418. In this embodiment, the semiconductor wafer 102 is reoriented (e.g., flipped) in a backside-up configuration with the active side placed on a dicing tape 508. The dicing tape 508 is configured for supporting the semiconductor wafer 102 during backside cut and die singulation procedures, for example. In this embodiment, the cut 502 is formed having a predetermined width dimension 506 and extends from the backside surface of the semiconductor wafer 102 to the base portion of the singulation feature 418. The hollow portion of the singulation feature 418 is exposed at the backside of the semiconductor wafer 102 by way of the cut 502. The cut 502 may be formed by way of a cutting apparatus 504 such as a mechanical saw or a laser, for example. In this embodiment, the cut 502 is configured having the width dimension 506 larger than the width dimension 304 of the opening 302 (of FIG. 4).

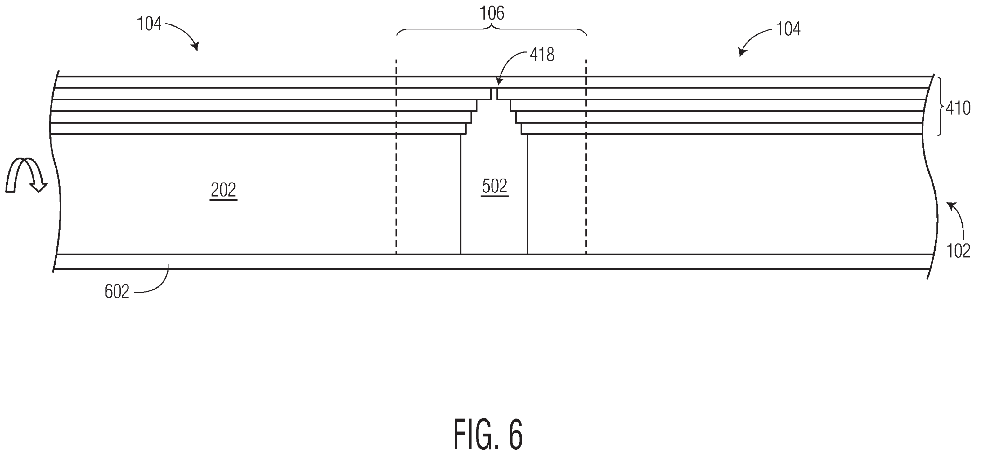

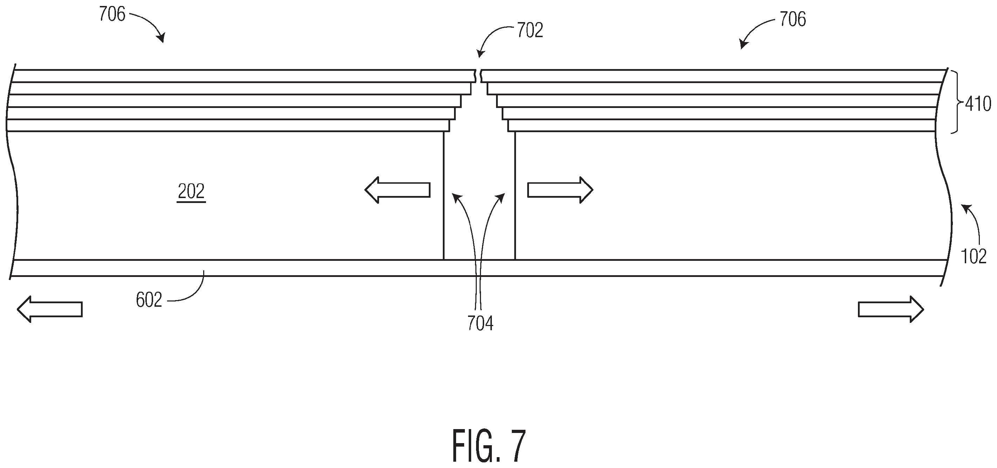

With the semiconductor wafer temporarily adhered on the dicing tape 508 after the cut 502 is formed, the dicing tape 508 may be expanded (e.g., laterally stretched) to singulate the semiconductor wafer 102 into a plurality of semiconductor die. The singulation feature 418 is configured to guide crack propagation to a portion of the semiconductor wafer directly overlying the top portion of the singulation feature as the dicing tape 508 is stretched during a wafer singulation procedure. Alternative singulation steps are depicted in FIG. 6 and FIG. 7.

FIG. 6 illustrates, in a simplified cross-sectional view, the example semiconductor wafer 102 at a subsequent stage of manufacture in accordance with an embodiment. At this stage, the semiconductor wafer 102 is reoriented (e.g., flipped) in an active-side-up configuration and placed on a second dicing tape 602 of a dicing apparatus (not shown) in preparation for die singulation. The dicing tape 602 is configured for supporting the semiconductor wafer 102 during a die singulation procedure, for example. In this embodiment, the semiconductor wafer 102 is separated from the dicing tape 508 after forming the cut 502 (FIG. 5) and placed onto the dicing tape 602 such that the backside of the semiconductor wafer 102 is temporarily adhered to the dicing tape 602.

FIG. 7 illustrates, in a simplified cross-sectional view, the example semiconductor wafer 102 at a subsequent stage of manufacture in accordance with an embodiment. At this stage, the semiconductor wafer 102 is singulated during a wafer singulation procedure to form a plurality of individual semiconductor die 706. In this embodiment, the wafer singulation procedure includes laterally stretching the dicing tape 602 in directions perpendicular to the singulation lane regions 106 sufficient to cause fractures (e.g., separation) 702 in the portion of the semiconductor wafer 102 directly above the top portion of the singulation feature 418 of FIG. 6. For example, stretching the dicing tape 602 ultimately creates separation 702 between neighboring die sites across the semiconductor wafer 102 such that the wafer is singulated into a plurality of individual semiconductor die 706. In this embodiment, the singulation feature (418 of FIG. 6) is configured to guide crack (e.g., fracture) propagation to a portion of the semiconductor wafer 102 directly overlying the top portion of the singulation feature as the dicing tape 602 is stretched during the wafer singulation procedure.

By singulating the semiconductor wafer 102 into the plurality of individual semiconductor die 706 in this manner, each semiconductor die 706 is virtually free of surface damage at the active side commonly associated with conventional singulation methods. Further, each semiconductor die 706 has a resulting sidewall profile 704 which allows the active area to be maximized and the width of the singulation lane regions to be minimized. In this embodiment, each of the individual semiconductor die 706 includes the sidewall profile 704 having a portion of the active side overhanging the sidewall at the backside. After the semiconductor wafer 102 is singulated into the plurality of individual semiconductor die 706, the die may be packaged to form semiconductor devices at subsequent stages of manufacture.

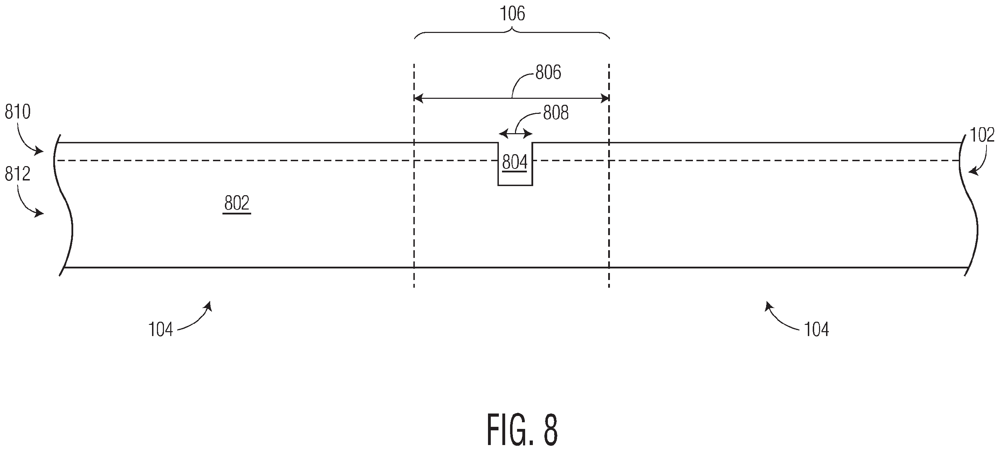

FIG. 8 through FIG. 14 illustrate, in simplified active-side-up cross-sectional views, the example semiconductor wafer 102 having an alternative embedded singulation feature at stages of manufacture in accordance with an embodiment. The cross-sectional views depicted in FIG. 8 through FIG. 14 show portions of neighboring die sites 104 separated from one another by way of singulation lane regions 106, for example.

FIG. 8 illustrates, in a simplified cross-sectional view, the example semiconductor wafer 102 at a stage of manufacture in accordance with an embodiment. At this stage, the alternative singulation feature includes a trench 804 formed in the singulation lane regions 106 at the active side semiconductor wafer 102. The trench 804 is configured as a lower portion of the embedded singulation feature. For illustration purposes, the substrate portion 802 includes the FEOL portion 810 together with the underlying bulk portion 812 of the semiconductor wafer 102. The FEOL portion 810 of the semiconductor wafer 102 generally includes transistors and circuit components, for example. The BEOL portion of the semiconductor wafer 102 is formed over the FEOL portion 810 at subsequent stages of manufacture. The BEOL portion of the semiconductor wafer 102 generally includes interconnect layers configured for interconnecting the transistors and circuit components of the FEOL portion, for example. Features of the semiconductor wafer 102 such as interconnecting traces of the BEOL and circuitry of the FEOL are not shown for illustration purposes.

In this embodiment, the trench 804 extends through the FEOL portion 810 and into the bulk portion 812 of the substrate portion 802 of the semiconductor wafer 102. In some embodiments, the trench 804 may be formed within the FEOL portion 810. The trench 804 be formed by way of known deep trench isolation process techniques, for example. In this embodiment, the trench 804 is substantially centered within the singulation lane region 106 and configured to substantially surround each die site 104. The singulation lane region 106 is formed having a predetermined width dimension 806 and the trench 804 is formed having a predetermined width dimension 808. By forming the alternative singulation feature within the singulation lane 106, the width dimension 806 may be reduced (e.g., width dimension equal to 30 microns or less) thus allowing more die per wafer.

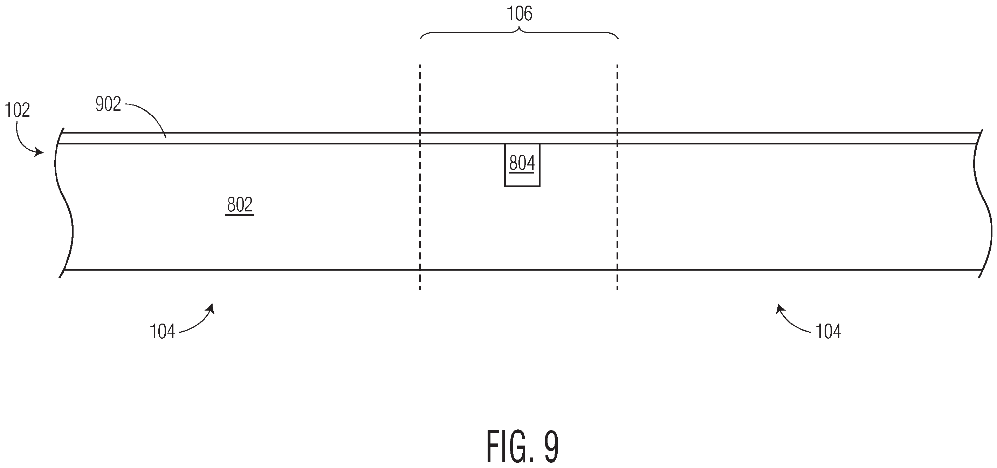

FIG. 9 illustrates, in a simplified cross-sectional view, the example semiconductor wafer 102 at a subsequent stage of manufacture in accordance with an embodiment. At this stage, the semiconductor wafer 102 includes a base dielectric layer 902 formed over the substrate portion 802 and trench 804. In this embodiment, the dielectric layer 902 is associated with a dielectric layer of the BEOL portion of the semiconductor wafer 102. For example, the BEOL portion of the semiconductor wafer 102 generally includes interconnect layers separated from one another by way of dielectric layers.

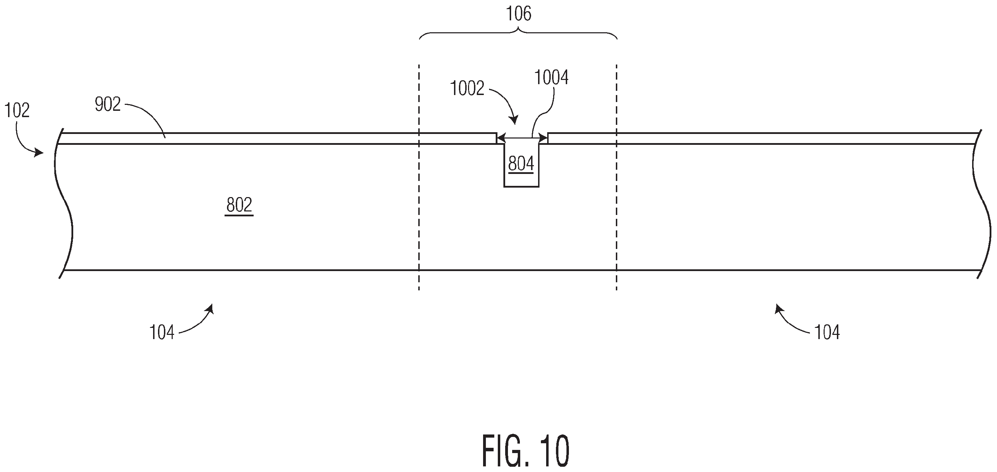

FIG. 10 illustrates, in a simplified cross-sectional view, the example semiconductor wafer 102 at a subsequent stage of manufacture in accordance with an embodiment. At this stage, an opening 1002 is formed through the dielectric layer 902 exposing the trench 804 within the singulation lane region 106 of the semiconductor wafer 102. The opening 1002 be formed by way of known etch or laser drilling techniques, for example. In this embodiment, the opening 1002 is substantially centered over the trench 804 within the singulation lane region 106 and configured to substantially surround each die site 104. In this embodiment, the opening 1002 is formed having a predetermined width dimension 1004 in a range of approximately 2 microns to 5 microns. In this embodiment, the width dimension 1004 of the opening 1002 is larger than the width dimension 808 (FIG. 8) of the trench 804.

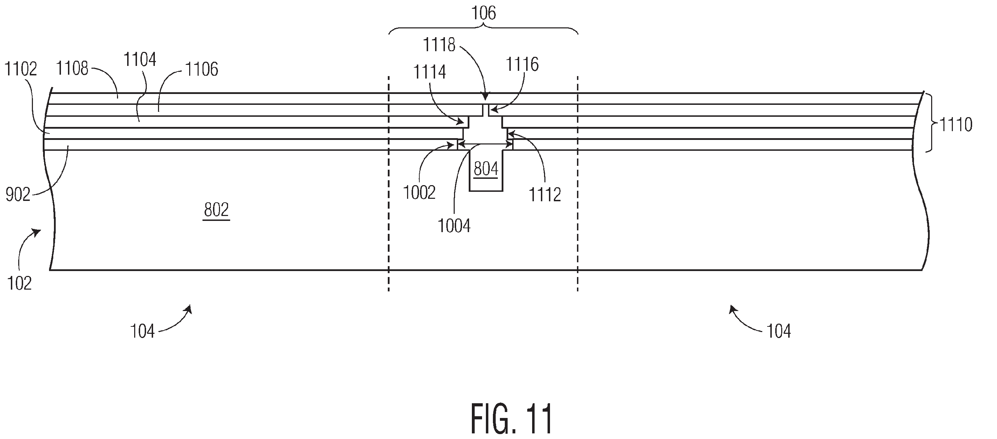

FIG. 11 illustrates, in a simplified cross-sectional view, the example semiconductor wafer 102 at a subsequent stage of manufacture in accordance with an embodiment. At this stage, dielectric layers 1102-1106 and respective openings 1112-1116 are successively formed over the base dielectric layer 902. In this embodiment, an upper portion (e.g., openings 1002, 1112-1114 formed in the dielectric layers 902, 1102-1106) of the embedded singulation feature 1118 is formed during the formation of the BEOL portion 1110 of the semiconductor wafer 102.

The dielectric layer 1102 is formed over the dielectric layer 902. The corresponding opening 1112 is subsequently formed through the dielectric layer 1102 such that the width of the opening 1112 is smaller than the width 1004 of the opening 1002. Similarly, the dielectric layer 1104 is formed over the dielectric layer 1102 with corresponding opening 1114 subsequently formed through the dielectric layer 1104 such that the width of the opening 1114 is smaller than the width of the opening 1112. Likewise, the dielectric layer 1106 is formed over the dielectric layer 1104 with corresponding opening 1116 subsequently formed through the dielectric layer 1106 such that the width of the opening 1116 is smaller than the width of the opening 1114. The dielectric layer 1108 is formed over the dielectric layer 1106 and the opening 1116 to embed the singulation feature 1118. Subsequent layers which may be formed over the dielectric layer 1108 are not shown for illustration purposes.

The top of the opening 1116 may be characterized as the tip or top portion of the embedded singulation feature 1118, for example. The openings 1112-1116 may be formed by way of known techniques (e.g., etching, laser drilling). In this embodiment, the embedded singulation feature 1118 includes the openings 1002 and 1112-1116 along with the trench 804 together formed as a hollow, air-filled structure formed in the singulation lane regions 106 and thus, substantially surrounds each die site 104 of the semiconductor wafer 102. In this embodiment, the upper portion of the embedded singulation feature 1118 includes a cross-sectional appearance having a substantially teardrop shape. For example, the top portion of the singulation feature 1118 is substantially narrower than the base portion of the singulation feature. Each underlying opening (1004, 1112, 1114) is progressively wider than the opening 1116 at the top portion of the singulation feature 1118.

In this embodiment, the dielectric layers 1102-1106 are associated with corresponding dielectric layers of the BEOL portion 1110 of the semiconductor wafer 102. The dielectric layer 1108 may be formed from a dielectric layer associated with a dielectric layer of the BEOL portion 1110 or may be formed from one or more other dielectric and/or passivation layers. The number of dielectric layers, size and shape of respective openings are chosen for illustration purposes.

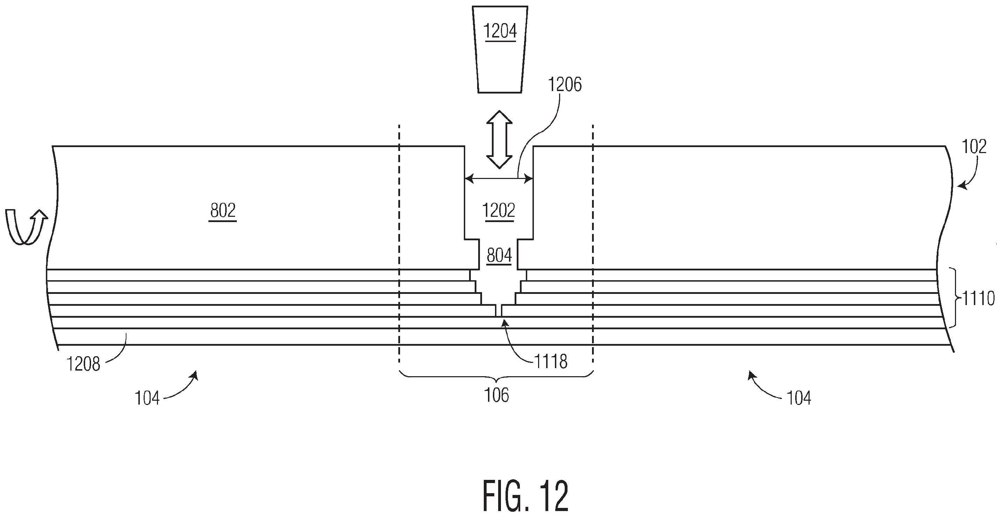

FIG. 12 illustrates, in a simplified cross-sectional view, the example semiconductor wafer 102 at a subsequent stage of manufacture in accordance with an embodiment. At this stage, a cut 1202 is formed at the backside of the semiconductor wafer 102 along the singulation lane regions 106 and substantially aligned with the trench 804 of the embedded singulation feature 1118. In this embodiment, the semiconductor wafer 102 is reoriented (e.g., flipped) in a backside-up configuration with the active side placed on a dicing tape 1208. The dicing tape 1208 is configured for supporting the semiconductor wafer 102 during backside cut and die singulation procedures, for example. In this embodiment, the cut 1202 is formed having a predetermined width dimension 1206 and extends from the backside surface of the semiconductor wafer 102 to the lower portion (e.g., trench 804) of the singulation feature 1118. The hollow portion of the singulation feature 1118 is exposed at the backside of the semiconductor wafer 102 by way of the cut 1202. The cut 1202 may be formed by way of a cutting apparatus 1204 such as a mechanical saw or a laser, for example. In this embodiment, the cut 1202 is configured having the width dimension 1206 larger than the width dimension 808 of the trench 804 (FIG. 8).

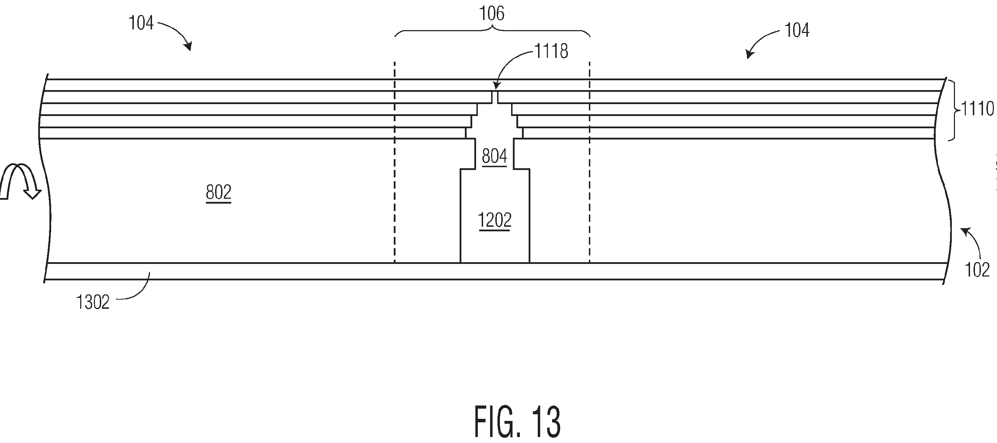

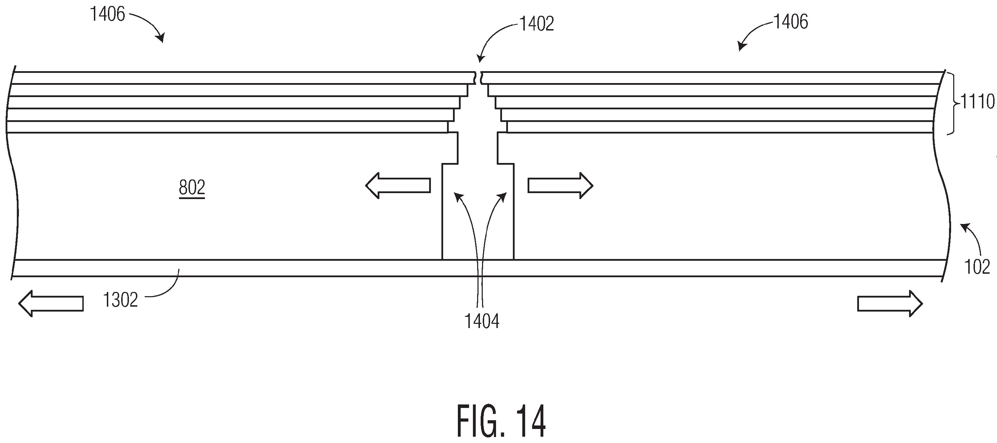

With the semiconductor wafer temporarily adhered on the dicing tape 1208 after the cut 1202 is formed, the dicing tape 1208 may be expanded (e.g., laterally stretched) to singulate the semiconductor wafer 102 into a plurality of semiconductor die. The singulation feature 1118 is configured to guide crack propagation to a portion of the semiconductor wafer directly overlying the top portion of the singulation feature as the dicing tape 1208 is stretched during a wafer singulation procedure. Alternative singulation steps are depicted in FIG. 13 and FIG. 14.

FIG. 13 illustrates, in a simplified cross-sectional view, the example semiconductor wafer 102 at a subsequent stage of manufacture in accordance with an embodiment. At this stage, the semiconductor wafer 102 is reoriented (e.g., flipped) in an active-side-up configuration and placed on a second dicing tape 1302 of a dicing apparatus (not shown) in preparation for die singulation. The dicing tape 1302 is configured for supporting the semiconductor wafer 102 during a die singulation procedure, for example. In this embodiment, the semiconductor wafer 102 is separated from the dicing tape 1208 after forming after forming the cut 1202 (FIG. 12) and placed onto the dicing tape 1302 such that the backside of the semiconductor wafer 102 is temporarily adhered to the dicing tape 1302.

FIG. 14 illustrates, in a simplified cross-sectional view, the example semiconductor wafer 102 at a subsequent stage of manufacture in accordance with an embodiment. At this stage, the semiconductor wafer 102 is singulated during a wafer singulation procedure to form a plurality of individual semiconductor die 1406. In this embodiment, the wafer singulation procedure includes laterally stretching the dicing tape 1302 in directions perpendicular to the singulation lane regions 106 sufficient to cause fractures (e.g., separation) 1402 in the portion of the semiconductor wafer 102 directly above the top portion of the singulation feature 1118 of FIG. 13. For example, stretching the dicing tape 1302 ultimately creates separation 1402 between neighboring die sites across the semiconductor wafer 102 such that the wafer is singulated into a plurality of individual semiconductor die 1406. In this embodiment, the singulation feature (1118 of FIG. 13) is configured to guide crack (e.g., fracture) propagation to a portion of the semiconductor wafer 102 directly overlying the top portion of the singulation feature as the dicing tape 1302 is stretched during the wafer singulation procedure.

By singulating the semiconductor wafer 102 into the plurality of individual semiconductor die 1406 in this manner, each semiconductor die 1406 is virtually free of surface damage at the active side commonly associated with conventional singulation methods. Further, each semiconductor die 1406 has a resulting sidewall profile 1404 which allows the active area to be maximized and the width of the singulation lane regions to be minimized. In this embodiment, each of the individual semiconductor die 1406 includes the sidewall profile 1404 having a portion of the active side overhanging the sidewall at the backside. After the semiconductor wafer 102 is singulated into the plurality of individual semiconductor die 1406, the die may be packaged to form semiconductor devices at subsequent stages of manufacture.

Generally, there is provided, a method including forming a singulation feature within singulation lane regions at an active side of a semiconductor wafer, a base portion of the singulation feature having a width greater than that of a top portion of the singulation feature; forming a cut at a backside of the semiconductor wafer along the singulation lane regions, a bottom portion of the cut extending to the base portion of the singulation feature; mounting the semiconductor wafer onto a dicing tape; and stretching the dicing tape to singulate the semiconductor wafer into a plurality of individual semiconductor die. The singulation feature may be embedded in the back end of line (BEOL) portion of the semiconductor wafer. The singulation feature may further include a trench that extends from the BEOL portion of the semiconductor wafer and into a bulk portion of the semiconductor wafer. The singulation feature may be formed as a hollow, air-filled structure that substantially surrounds each die site of the semiconductor wafer. The singulation feature may include a cross-section having a substantially teardrop shape. The singulation feature may be configured to guide crack propagation to a portion of the semiconductor wafer overlying the top portion of the singulation feature during the stretching of the dicing tape to singulate the semiconductor wafer into the plurality of individual semiconductor die. Each of the individual semiconductor die may include a sidewall having a portion of the active side overhanging the backside. The forming the cut at the backside of the semiconductor wafer may include forming the cut by way of a mechanical saw or a laser apparatus. The singulation lane regions at the active side of the semiconductor wafer may have a width dimension equal to 30 microns or less.

In another embodiment, there is provided, a semiconductor wafer including a plurality of die sites formed on the semiconductor wafer, each die site of the plurality of die sites surrounded by singulation lane regions; and a singulation feature embedded within the singulation lane regions at an active side of the semiconductor wafer, a base portion of the singulation feature having a width greater than that of a top portion of the singulation feature. The singulation feature may be embedded within dielectric layers associated with the back end of line (BEOL) portion of the semiconductor wafer. The semiconductor wafer may further include a trench extending from the BEOL portion of the semiconductor wafer and into a bulk portion of the semiconductor wafer, the base portion of the singulation feature formed directly over the trench. The singulation feature may be formed as a hollow, air-filled structure substantially surrounding each die site of the semiconductor wafer. The singulation feature may include a cross-section having a substantially teardrop shape. The singulation feature may be configured to guide crack propagation to a portion of the semiconductor wafer overlying the top portion of the singulation feature during a singulation procedure.

In yet another embodiment, there is provided, a method including forming a singulation feature within dielectric layers of singulation lane regions at an active side of a semiconductor wafer, the singulation feature having a top portion and a base portion, the base portion formed over a trench in the semiconductor wafer; mounting the semiconductor wafer onto a dicing tape; forming a cut at a backside of the semiconductor wafer along the singulation lane regions, the cut extending from the backside to a bottom of the trench; and stretching the dicing tape to singulate the semiconductor wafer into a plurality of individual semiconductor die. The singulation feature may be embedded within dielectric layers associated with the back end of line (BEOL) portion of the semiconductor wafer. The trench may extend from the BEOL portion of the semiconductor wafer and into a bulk portion of the semiconductor wafer. The singulation feature may be formed as a hollow, air-filled structure that substantially surrounds each die site of the semiconductor wafer. The singulation feature may include a cross-section having a substantially teardrop shape.

By now, it should be appreciated that there has been provided, a semiconductor wafer singulation method having an embedded singulation feature. The semiconductor wafer includes a plurality of die sites surrounded by singulation lanes. The singulation lanes of the semiconductor wafer include an embedded singulation feature at the active side which substantially surrounds each die site. The singulation feature is formed as hollow structure embedded within dielectric layers during the formation of the back end of line portion of the semiconductor wafer. The singulation feature has a teardrop-like shape in a cross-sectional view. For example, a the singulation feature has a very narrow top portion near the top surface of the semiconductor wafer and a progressively wider shape further from the top surface of the semiconductor wafer. A cut is formed from the back of the semiconductor wafer along the singulation lanes. The cut is vertically aligned with the singulation feature and extends from the bottom surface of the wafer to the singulation feature. With the semiconductor wafer adhered on a dicing tape, the dicing tape is expanded to singulate the semiconductor wafer into a plurality of semiconductor die. The singulation feature is configured to guide crack propagation to a portion of the semiconductor wafer directly overlying the top portion of the singulation feature as the dicing tape is stretched during a wafer singulation procedure. By singulating the semiconductor wafer into the plurality of individual semiconductor die in this manner, each semiconductor die is virtually free of surface damage at the active side commonly associated with conventional singulation methods. Further, each semiconductor die has a resulting sidewall profile allowing the active area to be maximized and the width of the singulation lane regions to be minimized thus enabling more possible die per wafer.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a singulation feature within singulation lane regions at an active side of a semiconductor wafer, a base portion of the singulation feature having a width greater than that of a top portion of the singulation feature;
forming a cut at a backside of the semiconductor wafer along the singulation lane regions, a bottom portion of the cut extending to the base portion of the singulation feature;
mounting the semiconductor wafer onto a dicing tape; and
stretching the dicing tape to singulate the semiconductor wafer into a plurality of individual semiconductor die.

2. The method of claim 1, wherein the singulation feature is embedded in the back end of line, BEOL, portion of the semiconductor wafer.

3. The method of claim 2, wherein the singulation feature further comprises a trench that extends from the BEOL portion of the semiconductor wafer and into a bulk portion of the semiconductor wafer.

4. The method of any preceding claim, wherein the singulation feature is formed as a hollow, air-filled structure that substantially surrounds each die site of the semiconductor wafer.

5. The method of any preceding claim, wherein the singulation feature includes a cross-section having a substantially teardrop shape.

6. The method of any preceding claim, wherein the singulation feature is configured to guide crack propagation to a portion of the semiconductor wafer overlying the top portion of the singulation feature during the stretching of the dicing tape to singulate the semiconductor wafer into the plurality of individual semiconductor die.

7. The method of any preceding claim, wherein each of the individual semiconductor die includes a sidewall having a portion of the active side overhanging the backside.

8. The method of any preceding claim1, wherein forming the cut at the backside of the semiconductor wafer includes forming the cut by way of a mechanical saw or a laser apparatus.

9. The method of any preceding claim, wherein the singulation lane regions at the active side of the semiconductor wafer have a width dimension equal to 30 microns or less.

10. A semiconductor wafer comprising:
a plurality of die sites formed on the semiconductor wafer, each die site of the plurality of die sites surrounded by singulation lane regions; and
a singulation feature embedded within the singulation lane regions at an active side of the semiconductor wafer, a base portion of the singulation feature having a width greater than that of a top portion of the singulation feature.

11. The semiconductor wafer of claim 10, wherein the singulation feature is embedded within dielectric layers associated with the back end of line, BEOL, portion of the semiconductor wafer.

12. The semiconductor wafer of claim 11, further comprising a trench extending from the BEOL portion of the semiconductor wafer and into a bulk portion of the semiconductor wafer, the base portion of the singulation feature formed directly over the trench.

13. The semiconductor wafer of any of claims 10 to12, wherein the singulation feature is formed as a hollow, air-filled structure substantially surrounding each die site of the semiconductor wafer.

14. The semiconductor wafer of any of claims 10 to 13, wherein the singulation feature includes a cross-section having a substantially teardrop shape.

15. The semiconductor wafer of any of claims 10 to 14, wherein the singulation feature is configured to guide crack propagation to a portion of the semiconductor wafer overlying the top portion of the singulation feature during a singulation procedure.
